# EUROPÄISCHE PATENTSCHRIFT

(11) **EP 1 310 036 B1**
(45) Veröffentlichungstag und Bekanntmachung des Hinweises auf die Patenterteilung: **12.05.2004**
(21) Anmeldenummer: 01945246.5
(22) Anmeldetag: 02.06.2001
(51) Int. Cl.: H02M 3/28, H02J 5/00

(54) **ENERGIEVERSORGUNGSEINHEIT ZUR ÜBERTRAGUNG VON HILFSENERGIE FÜR EINE ELEKTRISCHE ANORDNUNG**
ENERGY SUPPLY UNIT FOR TRANSMITTING AUXILIARY ENERGY TO AN ELECTRICAL DEVICE
UNITE D'ALIMENTATION D'ENERGIE DESTINEE A TRANSMETTRE UNE ENERGIE AUXILIAIRE A UN DISPOSITIF ELECTRIQUE

(30) Priorität: 14.08.2000 DE 10039707
(43) Veröffentlichungstag der Anmeldung: 14.05.2003
(73) Patentinhaber: Alstom, 75116 Paris (FR)
(72) Erfinder: JAKOB, Roland, 12524 Berlin (DE); RUDNISKI, David, Toronto, Ontario M6P 3B2 (CA); JUNGE, Günter, 13509 Berlin (DE)
(74) Vertreter: Dreiss, Fuhlendorf, Steimle & Becker
(86) Internationale Anmeldenummer: PCT/EP2001/006325
(87) Internationale Veröffentlichungsnummer: WO 2002/015375

(56) Entgegenhaltungen:
- EP-A- 0 817 351
- DE-A- 19 802 473
- DE-A- 19 948 454
- US-A- 3 409 805
- US-A- 4 622 627
- US-A- 4 713 723
- US-A- 5 949 155
- JANSON K, JARVIK J: "AC-DC CONVERTER WITH PARAMETRIC REACTIVE POWER COMPENSATION" IEEE TRANSACTIONS ON INDUSTRIAL ELECTRONICS, Bd. 46, Nr. 3, Juni 1999 (1999-06), Seiten 554-562, XP002179472 USA
- TANG S C ET AL: "CHARACTERIZATION OF CORELESS PRINTED CIRCUIT BOARD (PCB) TRANSFORMERS" 30TH ANNUAL IEEE POWER ELECTRONICS SPECIALISTS CONFERENCE. PESC 99. RECORD. CHARLESTON,, ANNUAL POWER ELECTRONICS SPECIALISTS CONFERENCE, NEW YORK, NY: IEEE, US, Bd. 2, 1999, Seiten 746-752, XP000924533 ISBN: 0-7803-5422-2

## Beschreibung

Die vorliegende Erfindung betrifft eine Energieversorgungseinheit zur Übertragung von Hilfsenergie für eine elektrische Anordnung, insbesondere für eine Steuerschaltung in einer Mittel- oder Hochspannungsanlage. Die Energieversorgungseinheit weist eine Primärspule, die zumindest mittelbar mit einer Energiequelle in Verbindung steht, eine Sekundärspule, die zumindest mittelbar mit der Steuerschaltung in Verbindung steht, und eine zwischen der Primärspule und der Sekundärspule ausgebildete Isolationsstrecke auf, über die die Übertragung der Hilfsenergie mittels eines magnetischen Wechselfeldes erfolgt.

Aus dem Stand der Technik sind in Multilevelschaltung aufgebaute Stromrichter für den Einsatz in Mittel- und Hochspannungsanlagen bekannt (vgl. US 5,737,201 und EP 0 944 163 A1). Eine Multilevelschaltung erlaubt einen modularen Aufbau eines Stromrichters. Jedes der Module umfasst mindestens zwei Halbleiter-Leistungsschalter und mindestens einen zwischen den Leistungsschaltern angeordneten Kondensator. Die Besonderheit der Multilevelschaltung besteht darin, dass die Kondensatoren nicht alle auf demselben Potential liegen, sondern auf verschiedene Potentiale bezogen werden können (sog. "floating capacitors"). Eine Zwischenkreisspannung wird derart an mehrere "floating capacitors" weitergegeben, dass sich die Spannungsbeanspruchung eines Halbleiter-Leistungsschalters als Differenz der Spannungen zweier Kondensatoren ergibt.

Bei in Multilevelschaltung aufgebauten Stromrichtern muss eine Energieversorgungseinheit - wie bei Stromrichterschaltungen mit in Reihe geschalteten Halbleiter-Leistungsschaltern - die Hilfsenergie für eine Steuerschaltung zur Ansteuerung der verschiedenen Leistungsschalter auf unterschiedlichen, hohen Potentialen zur Verfügung stellen. Auch bei anderen Hilfseinrichtungen, wie bspw. Messkreisen, muss eine Energieversorgung auf hohem Potential sichergestellt werden.

Für die Energieversorgung von Stromrichtern sind aus dem Stand der Technik verschiedene Energieversorgungseinheiten bekannt. So ist bspw. eine Einzel-Spannungsversorgung bekannt, bei der die Energieübertragung und eine Potentialtrennung für die einzelnen Halbleiter-Leistungsschalter durch herkömmliche, vorgefertigte Impulsübertrager mit Ferritkern erfolgt, wobei die Wicklungen der Übertrager mittels Vergussmasse gegeneinander isoliert sind. Allerdings ist es technisch sehr aufwendig, solche Energieversorgungseinheiten für derart hohe Isolationsspannungen zu fertigen, wie sie bei Steuerschaltungen für Mittel- und Hochspannungsanlagen auftreten. Dem entsprechend teuer sind diese bekannten Energieversorgungseinheiten.

Des weiteren sind Energieversorgungseinheiten mit einer gemeinsamen Spannungsversorgung über eine Mittelfrequenz (MF)-Ringleitung bekannt. Die MF-Ringleitung wird von einem zentral angeordneten MF-Konverter mit mittelfrequentem Wechselstrom im Bereich von einigen 10 kHz gespeist. Die MF-Ringleitung besteht aus einem isolierten Hochvolt (HV)-Kabel, das in dem Stromrichter verläuft, was zu einer relativ hohen Streuinduktivität führt. Die Energieauskopplung zu den auf unterschiedlichen elektrischen Potentialen befindlichen Halbleiter-Leistungsschalter-Treibern wird mit Hilfe von Ferritkernen vorgenommen, die das HV-Kabel umfassen. Die Potentialtrennung muss dabei entweder die Isolation des HV-Kabels vollständig übernehmen, an die dann entsprechend hohe Anforderungen bzgl. Glimmspannungsfestigkeit zu stellen sind (z. B. Teflon-Kabel), oder der Luftabstand zwischen Kabelmantel und Ferritkern muss ausreichend groß bemessen werden, um Überschläge zum Kernmaterial sicher zu vermeiden.

Der vorliegenden Erfindung liegt die Aufgabe zu Grunde, eine Energieversorgungseinheit der eingangs genannten Art dahingehend auszugestalten und weiterzubilden, dass sie eine geringe Streuinduktivität und eine große Kopplungsinduktivität erzeugt und einen einfachen und kostengünstigen Aufbau aufweist.

Zur Lösung dieser Aufgabe schlägt die Erfindung ausgehend von der Energieversorgungseinheit der eingangs genannten Art vor, dass eine als Flachspule ausgebildete Primärspule auf einer ersten Trägerplatte und eine als Flachspule ausgebildete Sekundärspule auf einer zweiten Trägerplatte ausgebildet ist, die beiden Trägerplatten in einem definierten Abstand zueinander angeordnet sind und die Isolationsstrecke als ein zwischen der Primärspule und der Sekundärspule ausgebildeter Luftspalt ausgebildet ist.

Bei der erfindungsgemäßen Energieversorgungseinheit wird Luft als Isolationsmedium genutzt. Dadurch ist eine Alterung der Isolation durch Teilentladungen im Isolationsmaterial nicht möglich. Die Energieversorgungseinheit weist also eine extrem hohe Teilentladungsfestigkeit auf. Eine Teilentladungsprüfung als Bauteilprüfung im Rahmen der Fertigung der Energieversorgungseinheit ist nicht erforderlich. Zudem kann die Isolationsstrecke sichtbar gestaltet werden, so dass verdeckte Mängel kaum möglich sind. Schließlich weist die erfindungsgemäße Energieversorgungseinheit einen einfachen Aufbau auf und ist auf besonders einfache Weise für unterschiedliche Isolations- und Leistungsanforderungen skalierbar.

Die Trägerplatten bestehen aus einem beliebigen Isolationsmaterial, vorzugsweise aus Kunststoff. Die Primärspule und die Sekundärspule können auf beliebige Weise auf die Trägerplatten aufgebracht sein. Es ist insbesondere daran gedacht, dass die Flachspulen nach einem an sich aus der Mikroelektronik bekannten lithographischen oder Dünnschicht-Verfahren auf die Trägerplatten aufgebracht werden. Die Länge der Luftstrecke zwischen den Spulen ist so ausgelegt, dass eine vorgebbare Isolationsspannung erreicht wird.

Die erfindungsgemäße Energieversorgungseinheit eignet sich insbesondere für den Einsatz in Stromrichtern (in Wechselrichtern oder in Gleichrichtern) von Mittel- oder Hochspannungsanlagen, bei denen die Hilfsenergie für eine Steuerschaltung zur Ansteuerung von Halbleiter-Leistungsschaltern auf unterschiedlichen, hohen Potentialen zur Verfügung gestellt werden muss. Die erfindungsgemäße Energieversorgungseinheit kann jedoch auch in beliebigen anderen elektrischen Anordnungen eingesetzt werden, insbesondere dort wo eine Energieversorgung auf hohem Potential gefordert ist, wie bspw. in Messkreisen.

Bei einer Versorgung einer Steuerschaltung für Halbleiter-Leistungsschalter in einem Stromrichter einer Mittel- oder Hochspannungsanlage mit Hilfsenergie kann es vorteilhaft sein, die Energieversorgungseinheit so zwischen einem Leistungsschalter und einem auf Massepotential liegenden Bauteil (Schrankwand, Chassis, etc.) des Stromrichters anzuordnen, dass sich die Primärseite der Energieversorgungseinheit nah an dem Masseteil und die Sekundärseite nah an dem Leistungsschalter befindet. Es ist denkbar, die Primärseite an dem auf Massepotential liegenden Bauteil und die Sekundärseite an dem Halbleiter-Leistungsschalter zu befestigen.

Selbstverständlich können auf der Sekundärseite der erfindungsgemäßen Energieversorgungseinheit - wie das auch bei herkömmlichen aus dem Stand der Technik bekannten Übertragern der Fall ist - auch mehrere Sekundärspulen angeordnet sein, so dass mit einem geringen Mehraufwand mehrere Spannungen erzeugt werden können.

Gemäß einer vorteilhaften Weiterbildung der vorliegenden Erfindung wird vorgeschlagen, dass die Hilfsenergie als eine Gleichspannung ausgebildet ist, wobei zwischen der Energiequelle und der Primärspule eine Oszillatorschaltung angeordnet ist, die aus einer Eingangsgleichspannung der Energiequelle eine Wechselspannung zur Speisung der Primärspule erzeugt, und zwischen der Sekundärspule und der Steuerschaltung eine Schaltung zur Gleichrichtung der Ausgangsspannung angeordnet ist. Gemäß dieser Weiterbildung wird also ein Gleichspannungsübertrager vorgeschlagen, der in Form von zwei Trägerplatten realisiert ist. Der Gleichspannungsübertrager überträgt die Energie in Form eines magnetischen Wechselfeldes über den Luftspalt von der auf der primärseitigen Trägerplatte integrierten Primärspule auf die in der sekundärseitigen Trägerplatte integrierte Sekundärspule. Die Eingangsgleichspannung kann durch herkömmliche Entstörmaßnahmen, bspw. geringes Arbeitsvolumen der Spulen, relativ leicht gegen hochfrequente (HF)-Störungen entstört werden.

Vorteilhafterweise stabilisiert und/oder glättet die Schaltung zur Gleichrichtung die Ausgangsspannung. Idealerweise weist die Wechselspannung einen zumindest annähernd sinusförmigen Verlauf auf. Die Oszillatorschaltung weist vorzugsweise einen Kondensator zur Kompensation von Blindleistung auf. Dadurch kann gegebenenfalls erforderliche Blindleistung durch den Kondensator unmittelbar in der Oszillatorschaltung kompensiert werden, so dass ein Gleichstrom mit einem geringen Oberwellenanteil aus der Gleichspannungsversorgung entnommen werden kann.

Vorteilhafterweise sind die Trägerplatten derart relativ zueinander angeordnet, dass der Mittelpunkt der Primärspule gegenüber dem Mittelpunkt der Sekundärspule angeordnet ist. Es ist bspw. denkbar, dass die beiden Trägerplatten aus einer spiegelbildlich genau gegenüberliegenden Stellung um 180° um eine imaginäre Verbindungslinie durch die beiden Mittelpunkte relativ zueinander verschwenkt angeordnet sind. Die Oszillatorschaltung auf der ersten Trägerplatte und die Schaltung zur Gleichrichtung auf der zweiten Trägerplatte sind dann in einem besonders großen Abstand zueinander angeordnet. Diese Maßnahme kann entscheidend zur Entstörung der erfindungsgemäßen Energieversorgungseinheit beitragen.

Gemäß einer anderen vorteilhaften Weiterbildung der vorliegenden Erfindung wird vorgeschlagen, dass die Primärspule und die Sekundärspule spiralförmig auf den Trägerplatten ausgebildet sind. Derart ausgebildete Spulen weisen eine besonders geringe Bauhöhe auf und können besonders kostengünstig gefertigt werden. Außerdem können - insbesondere auf der Sekundärseite - problemlos auch mehrere ineinandergreifende Spulen auf der Trägerplatte ausgebildet werden.

Gemäß einer bevorzugten Ausführungsform der vorliegenden Erfindung wird vorgeschlagen, dass in dem Luftspalt zwischen den Trägerplatten mindestens eine Isolierplatte angeordnet ist. Bei dieser Ausführungsform dient nach wie vor Luft als Isolationsmedium. Die mindestens eine Isolierplatte nimmt nur einen geringen Raum zwischen den Trägerplatten in Anspruch und somit auch nur einen geringen Teil der Spannung zwischen den Trägerplatten auf. An die Isolierplatte werden also nur geringe Anforderungen hinsichtlich der Teilentladungsfestigkeit gestellt. Ohne die Isolierplatte entspricht die Länge der Luftstrecke zwischen den beiden Spulen der Breite des Luftspalts. Durch die zwischen den Trägerplatten angeordnete Isolierplatte kann die Luftstrecke zwischen den Spulen bei gleichbleibendem Abstand zwischen den Trägerplatten deutlich verlängert werden. Die mindestens eine Isolierplatte besteht aus einem beliebigen Isolationsmaterial, bspw. aus Kunststoff.

Vorteilhafterweise ist in dem Luftspalt zwischen den Trägerplatten eine Isolierplatte angeordnet, die eine größere Fläche als die Trägerplatten aufweist, wobei die Ränder der Isolierplatte die Ränder der Trägerplatten seitlich überragen. Auf diese Weise kann die Luftstrecke zwischen den Spulen noch einmal verlängert werden. Durch die Wahl der Abmessungen der Isolierplatte kann die Länge der Luftstrecke nahezu beliebig variiert werden.

Gemäß einer weiteren bevorzugten Ausführungsform der vorliegenden Erfindung wird vorgeschlagen, dass die Trägerplatten zumindest im Bereich der Primärspule bzw. der Sekundärspule äquidistant zueinander angeordnet sind.

Vorteilhafterweise sind zwischen den Trägerplatten bzw. zwischen den Trägerplatten und der mindestens einen Isolierplatte Abstandshalter angeordnet. Durch die Abstandshalter kann der Abstand zwischen den Trägerplatten und damit zwischen den Spulen auf einem konstanten Wert gehalten werden. Die Trägerplatten bzw. die mindestens eine Isolierplatte sind vorzugsweise an den Abstandshaltern befestigt. Dadurch kann die Stabilität der erfindungsgemäßen Energieversorgungseinheit deutlich erhöht werden.

Vorzugsweise sind zwischen den Trägerplatten bzw. zwischen den Trägerplatten und der mindestens einen Isolierplatte jeweils drei Abstandshalter vorgesehen. Durch die drei Abstandshalter kann die Lage der Trägerplatten relativ zueinander bzw. die Lage der Isolierplatte relativ zu den Trägerplatten sicher, genau und eindeutig festgelegt werden.

Um zu vermeiden, dass sich über die Abstandshalter Kriechstrecken ausbilden, wird vorgeschlagen, dass die zwischen der ersten Trägerplatte und der mindestens einen Isolierplatte angeordneten Abstandshalter und die zwischen der zweiten Trägerplatte und der mindestens einen Isolierplatte angeordneten Abstandshalter versetzt zueinander an der mindestens einen Isolierplatte befestigt sind. Bei der erfindungsgemäßen Energieversorgungseinheit kann also die Luftstrecke und können die Kriechstrecken genau dimensioniert und an die gegebenen Anforderungen angepasst werden.

Schließlich wird vorgeschlagen, dass eine auf der ersten Trägerplatte als Flachspule ausgebildete weitere Spule im Bereich des magnetischen Wechselfeldes angeordnet ist, die an eine Kontrolleinheit angeschlossen ist. Die weitere Spule kann im Bereich der Primärspule, bspw. in die Primärspule eingreifend, angeordnet sein. Die Kontrolleinheit ist bspw. als eine Auswerteeinheit, die eine während eines ordnungsgemäßen Betriebs der Energieversorgungseinheit in der weiteren Spule induzierte Spannung auswertet, oder als eine Kontrollleuchte, insbesondere als eine Lumineszenzdiode (LED), ausgebildet, die während des Betriebs der Energieversorgungseinheit das ordnungsgemäße Anliegen eines Wechselfeldes anzeigt.

Weitere Merkmale, Anwendungsmöglichkeiten und Vorteile der Erfindung ergeben sich aus der nachfolgenden Beschreibung von Ausführungsbeispielen der Erfindung, die in der Zeichnung dargestellt sind. Dabei bilden alle beschriebenen oder dargestellten Merkmale für sich oder in beliebiger Kombination den Gegenstand der Erfindung, unabhängig von ihrer Zusammenfassung in den Patentansprüchen oder deren Rückbeziehung sowie unabhängig von ihrer Formulierung bzw. Darstellung in der Beschreibung bzw. in der Zeichnung. Es zeigen:
- Fig. 1: eine erfindungsgemäße Energieversorgungseinheit gemäß einem bevorzugten Ausführungsbeispiel in perspektivischer Ansicht; und
- Fig. 2: ein Blockschaltbild der erfindungsgemäßen Energieversorgungseinheit aus Fig. 1.

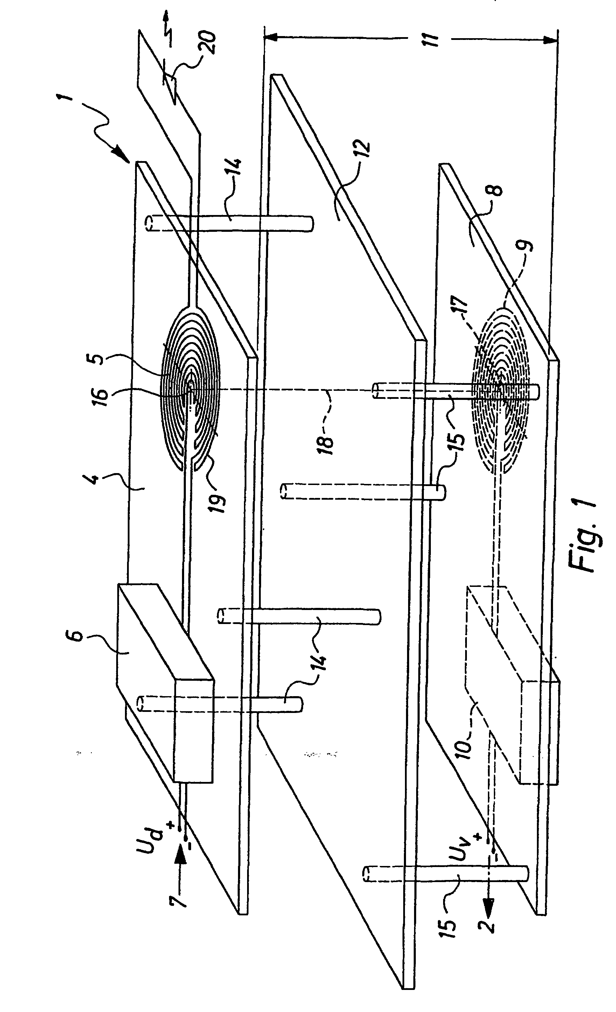

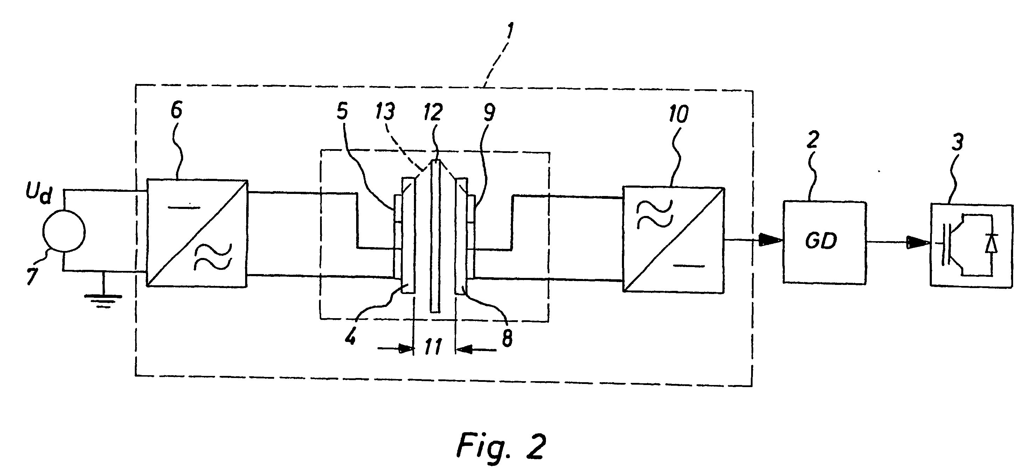

In Fig. 1 und Fig. 2 ist eine erfindungsgemäße Energieversorgungseinheit in ihrer Gesamtheit mit dem Bezugszeichen 1 bezeichnet. Die Energieversorgungseinheit 1 dient zur Übertragung von Hilfsenergie für eine Steuerschaltung 2 (sog. Gate Drive, GD; vgl. Fig. 2) in einem Stromrichter einer Mittel- oder Hochspannungsanlage. Die Steuerschaltung 2 dient zur Ansteuerung von Halbleiter-Leistungsschaltern 3 des Stromrichters. Der Stromrichter ist vorzugsweise in Multilevelschaltung ausgebildet. Die Steuerschaltung 2 stellt den Leistungsschaltern 3 unterschiedliche, hohe Potentiale zur Verfügung..Die Leistungsschalter 3 sind bspw. als IGBTs (Insulated Gate Bipolar Transistors) ausgebildet.

Die Energieversorgungseinheit 1 weist eine erste Trägerplatte 4 mit einer darauf als Flachspule ausgebildeten Primärspule 5 auf. Die Primärspule 5 steht über eine Oszillatorschaltung 6 mit einer als Gleichspannungsquelle U_d ausgebildeten Energiequelle 7 in Verbindung. Die Oszillatorschaltung 6 erzeugt aus einer Eingangsgleichspannung U_d der Energiequelle 7 eine Wechselspannung zur Speisung der Primärspule 5. Die Wechselspannung weist einen zumindest annähernd sinusförmigen Verlauf auf. Außerdem weist die Energieversorgungseinheit 1 eine zweite Trägerplatte 8 mit einer darauf als Flachspule ausgebildeten Sekundärspule 9 auf. Die Sekundärspule 9 steht über eine Schaltung 10 zur Gleichrichtung der Ausgangsspannung U_v mit der Steuerschaltung 2 in Verbindung. Die Schaltung 10 zur Gleichrichtung der Ausgangsspannung U_v führt außerdem eine Stabilisierung und/oder Glättung der Ausgangsspannung U_v durch. Selbstverständlich können auf der Sekundärseite 8, 9, 10 der erfindungsgemäßen Energieversorgungseinheit 1 - wie das auch bei herkömmlichen aus dem Stand der Technik bekannten Übertragern der Fall ist - auch mehrere Sekundärspulen 9 angeordnet sein, so dass mit einem geringen Mehraufwand mehrere Ausgangsspannungen U_v erzeugt werden können.

Zwischen der Primärspule 5 und der Sekundärspule 9 ist ein Luftspalt 11 ausgebildet. Der Luftspalt 11 entspricht dem Abstand der beiden Spulen 5, 9 zueinander. In dem Luftspalt 11 ist eine Isolierplatte 12 angeordnet, durch die eine Luftstrecke 13 zwischen den Spulen 5, 9 bei gleichbleibender Breite des Luftspalts 11 deutlich verlängert werden kann. Die Isolierplatte 12 weist eine größere Fläche als die Trägerplatten 4, 8 auf, wobei die Ränder der Isolierplatte 12 die Ränder der Trägerplatten 4, 8 seitlich überragen. Auf diese Weise kann die Luftstrecke 13 zwischen den Spulen 5, 9 noch einmal verlängert werden. Die Luftstrecke 13 ist so ausgelegt, dass eine vorgebbare Isolationsspannung erreicht wird. Die Isolierplatte 12 besteht aus einem beliebigen Isolationsmaterial, vorzugsweise aus Kunststoff. Die Hilfsenergie für die Steuerschaltung 2 wird mittels eines magnetischen Wechselfeldes über den Luftspalt 11 übertragen.

Die Trägerplatten 4, 8 bestehen aus einem beliebigen Isolationsmaterial, vorzugsweise aus Kunststoff. Die Spulen 5, 9 sind spiralförmig ausgebildet. Die Primärspule 5 und die Sekundärspule 9 sind auf beliebige Weise, vorzugsweise nach einem an sich aus der Mikroelektronik bekannten lithographischen oder Dünnschicht-Verfahren zur Fertigung von Leiterplatten, auf die Trägerplatten 4, 8 aufgebracht.

Die Trägerplatten 4, 8 sind äquidistant zueinander angeordnet. Ein Mittelpunkt 16 der Primärspule 5 ist gegenüber einem Mittelpunkt 17 der Sekundärspule 9 angeordnet. Es ist bspw. denkbar, dass die beiden Trägerplatten 4, 8 aus der in Fig. 1 dargestellten spiegelbildlich genau gegenüberliegenden Stellung um 180° um eine imaginäre Verbindungslinie 18 durch die beiden Mittelpunkte 16, 17 relativ zueinander verschwenkt werden. Der Abstand zwischen der Oszillatorschaltung 6 und der Schaltung 10 zur Gleichrichtung wäre dann besonders groß, was zu einer Entstörung der Energieversorgungseinheit 1 führen würde.

Es ist denkbar, dass die Primärseite 4, 5, 6 der Energieversorgungseinheit 1 an einem auf Massepotential liegenden Bauteil (Schrankwand, Chassis, etc.) des Stromrichters und die Sekundärseite 8, 9, 10 an dem Halbleiter-Leistungsschalter 2 befestigt ist. Da sowohl das auf Massepotential liegende Bauteil als auch der Leistungsschalter 2 üblicherweise eine genau definierte Position in dem Stromrichter haben, ist damit auch die Primärseite 4, 5, 6 und die Sekundärseite 8, 9, 10 genau positioniert und der Luftspalt 11 hat eine genau definierte Breite.

Alternativ oder zusätzlich kann der Luftspalt 11 durch Abstandshalter 14, 15 sicher und zuverlässig in der genau definierten Breite festgelegt werden. Drei Abstandshalter 14 sind zwischen der ersten Trägerplatte 4 und der Isolierplatte 12 angeordnet und an den Platten 4, 12 befestigt. Drei weitere Abstandshalter 15 sind zwischen der zweiten Trägerplatte 8 und der Isolierplatte 12 angeordnet und an den Platten 8, 12 befestigt. Um zu vermeiden, dass sich über die Abstandshalter 14, 15 Kriechstrecken ausbilden, sind die Abstandshalter 14 versetzt zu den Abstandshaltern 15 an der Isolierplatte 12 befestigt.

Schließlich ist auf der ersten Trägerplatte 4 eine als Flachspule ausgebildete weitere Spule 19 im Bereich des magnetischen Wechselfeldes angeordnet. Die weitere Spule 19 verläuft außen um die Primärspule 5 herum. Die weitere Spule 19 ist unmittelbar an eine als Lumineszenzdiode (LED) 20 ausgebildete Kontrolleinheit angeschlossen. Die LED 20 zeigt während des Betriebs der Energieversorgungseinheit 1 das Anliegen eines ordnungsgemäßen Wechselfeldes an.

## Patentansprüche

1. Energieversorgungseinheit (1) zur Übertragung von Hilfsenergie für eine Steuerschaltung (2) in einer Mittel- oder Hochspannungsanlage, wobei die Energieversorgungseinheit (1) eine Primärspule (5), die zumindest mittelbar mit einer Energiequelle (7) in Verbindung steht, eine Sekundärspule (9), die zumindest mittelbar mit der Steuerschaltung (2) in Verbindung steht, und eine zwischen der Primärspule (5) und der Sekundärspule (9) ausgebildete Isolationsstrecke, über die die Übertragung der Hilfsenergie mittels eines magnetischen Wechselfeldes erfolgt, aufweist, **dadurch gekennzeichnet, dass** eine als Flachspule ausgebildete Primärspule (5) auf einer ersten Trägerplatte (4) und eine als Flachspule ausgebildete Sekundärspule (9) auf einer zweiten Trägerplatte (8) ausgebildet ist, die beiden Trägerplatten (4, 8) in einem definierten Abstand zueinander angeordnet sind und die Isolationsstrecke als ein zwischen der Primärspule (5) und der Sekundärspule (9) ausgebildeter Luftspalt (11) ausgebildet ist.

2. Energieversorgungseinheit (1) nach Anspruch 1, **dadurch gekennzeichnet, dass** die Hilfsenergie als eine Gleichspannung (U_v) ausgebildet ist, wobei zwischen der Energiequelle (7) und der Primärspule (5) eine Oszillatorschaltung (6) angeordnet ist, die aus einer Eingangsgleichspannung (U_d) der Energiequelle (7) eine Wechselspannung zur Speisung der Primärspule (5) erzeugt, und zwischen der Sekundärspule (9) und der Steuerschaltung (2) eine Schaltung (10) zur Gleichrichtung der Ausgangsspannung (U_v) angeordnet ist.

3. Energieversorgungseinheit (1) nach Anspruch 2, **dadurch gekennzeichnet, dass** die Schaltung (10) zur Gleichrichtung die Ausgangsspannung (U_v) stabilisiert und/oder glättet.

4. Energieversorgungseinheit (1) nach Anspruch 2 oder 3, **dadurch gekennzeichnet, dass** die Wechselspannung einen zumindest annähernd sinusförmigen Verlauf aufweist.

5. Energieversorgungseinheit (1) nach einem der Ansprüche 2 bis 4, **dadurch gekennzeichnet, dass** die Osziliatorschaltung (6) einen Kondensator zur Kompensation von Blindleistung aufweist.

6. Energieversorgungseinheit (1) nach einem der Ansprüche 1 bis 5, **dadurch gekennzeichnet, dass** die Primärspule (5) und die Sekundärspule (9) spiralförmig auf den Trägerplatten (4, 8) ausgebildet sind.

7. Energieversorgungseinheit (1) nach Anspruch 6, **dadurch gekennzeichnet, dass** die Trägerplatten (4, 8) derart relativ zueinander angeordnet sind, dass der Mittelpunkt (16) der Primärspule (5) gegenüber dem Mittelpunkt (17) der Sekundärspule (9) angeordnet ist.

8. Energieversorgungseinheit (1) nach einem der Ansprüche 1 bis 7, **dadurch gekennzeichnet, dass** in dem Luftspalt (11) zwischen den Trägerplatten (4, 8) mindestens eine Isolierplatte (12) angeordnet ist.

9. Energieversorgungseinheit (1) nach Anspruch 8, **dadurch gekennzeichnet, dass** in dem Luftspalt (11) zwischen den Trägerplatten (4, 8) eine Isolierplatte (12) angeordnet ist, die eine größere Fläche als die Trägerplatten (4, 8) aufweist, wobei die Ränder der Isolierplatte (12) die Ränder der Trägerplatten (4, 8) seitlich überragen.

10. Energieversorgungseinheit (1) nach einem der Ansprüche 1 bis 9, **dadurch gekennzeichnet, dass** die Trägerplatten (4, 8) zumindest im Bereich der Primärspule (5) bzw. der Sekundärspule (9) äquidistant zueinander angeordnet sind.

11. Energieversorgungseiriheit (1) nach Anspruch 10, **dadurch gekennzeichnet, dass** zwischen den Trägerplatten (4, 8) bzw. zwischen den Trägerplatten (4, 8) und der mindestens einen Isolierplatte (12) Abstandshalter (14, 15) angeordnet sind.

12. Energieversorgungseinheit (1) nach Anspruch 11, **dadurch gekennzeichnet, dass** die Trägerplatten (4, 8) bzw. die mindestens eine Isolierplatte (12) an den Abstandshaltern (14, 15) befestigt sind.

13. Energieversorgungseinheit (1) nach Anspruch 11 oder 12, **dadurch gekennzeichnet, dass** zwischen den Trägerplatten (4, 8) bzw. zwischen den Trägerplatten (4, 8) und der mindestens einen Isolierplatte (12) jeweils drei Abstandshalter (14, 15) vorgesehen sind.

14. Energieversorgungseinheit (1) nach Anspruch 13, **dadurch gekennzeichnet, dass** die zwischen der ersten Trägerplatte (4) und der mindestens einen Isolierplatte (12) angeordneten Abstandshalter (14) und die zwischen der zweiten Trägerplatte (8) und der mindestens einen Isolierplatte (12) angeordneten Abstandshalter (15) versetzt zueinander an der mindestens einen Isolierplatte (12) befestigt sind.

15. Energieversorgungseinheit (1) nach einem der Ansprüche 1 bis 14, **dadurch gekennzeichnet, dass** eine auf der ersten Trägerplatte (4) als Flachspule ausgebildete weitere Spule (19) im Bereich des magnetischen Wechselfeldes angeordnet ist, die an eine Kontrolleinheit (20) angeschlossen ist.

## Claims

1. Energy supply unit (1) for transmitting auxiliary energy for a control circuit (2) in a medium or high voltage installation, wherein the energy supply unit (1) comprises a primary coil (5), which is coupled at least indirectly to an energy source (7), a secondary coil (9), which is coupled at least indirectly to the control circuit (2), and an insulation path, which is provided between the primary coil (5) and the secondary coil (9), by way of which the auxiliary energy is transmitted through the medium of an alternating magnetic field, **characterized in that** a primary coil (5) in the form of a pancake coil is provided on a first carrier plate (4) and a secondary coil (9) in the form of a pancake coil is provided on a second carrier plate (8), the two carrier plates (4, 8) being spaced apart by a predetermined distance and the insulation path being constituted by an airgap (11) provided between the primary coil (5) and the secondary coil (9).

2. Energy supply unit (1) according to Claim 1, **characterized in that** the auxiliary
energy is provided as a direct voltage (U_v), an oscillator circuit (6) being disposed between the energy source (7) and the primary coil (5) to generate from a direct input voltage (U_d) of the energy source (7) an alternating voltage to feed the primary coil (5), and a circuit (10) for rectifying the output voltage (U_v) being disposed between the secondary coil (9) and the control circuit (2).

3. Energy supply unit (1) according to Claim 2, **characterized in that** the rectifying circuit (10) stabilizes and/or smoothes the output voltage (U_v).

4. Energy supply unit (1) according to Claim 2 or Claim 3, **characterized in that** the alternating voltage has an at least approximately sinusoidal waveform.

5. Energy supply unit (1) according to any one of Claims 2 to 4, **characterized in that** the oscillator circuit (6) comprises a capacitor for compensating the reactive power.

6. Energy supply unit (1) according to any one of Claims 1 to 5, **characterized in that** the primary coil (5) and the secondary coil (9) are formed in a spiral shape on the carrier plates (4, 8).

7. Energy supply unit (1) according to Claim 6, **characterized in that** the carrier plates (4, 8) are disposed in relation to each other such that the centre (16) of the primary coil (5) lies opposite the centre (17) of the secondary coil (9).

8. Energy supply unit (1) according to any one of Claims 1 to 7, **characterized in that** at least one insulation plate (12) is disposed in the airgap (11) between the carrier plates (4, 8).

9. Energy supply unit (1) according to Claim 8, **characterized in that** an insulation plate (12) is disposed in the airgap (11) between the carrier plates (4, 8), the insulation plate having a larger area than the carrier plates (4, 8), the edges of the insulation plate (12) protruding laterally beyond the edges of the carrier plates (4, 8).

10. Energy supply unit (1) according to any one of Claims 1 to 9, **characterized in that** the carrier plates (4, 8) are disposed equidistantly from each other at least in the region of the primary coil (5) and secondary coil (9).

11. Energy supply unit (1) according to Claim 10, **characterized in that** spacers (14, 15) are disposed between the carrier plates (4, 8) or between the carrier plates (4, 8) and the at least one insulation plate (12).

12. Energy supply unit (1) according to Claim 11, **characterized in that** the carrier plates (4, 8) or the at least one insulation plate (12) are fixed to the spacers 15).

13. Energy supply unit (1) according to Claim 11 or Claim 12, **characterized in that** three spacers (14, 15) in each case are provided between the carrier plates (4, 8) or between the carrier plates (4, 8) and the at least one insulation plate (12).

14. Energy supply unit (1) according to Claim 13, **characterized in that** the spacers (14) arranged between the first carrier plate (4) and the at least one insulation plate (12) and the spacers (15) arranged between the second carrier plate (8) and the at least one insulation plate (12) are fixed in mutually staggered manner to the at least one insulation plate (12).

15. Energy supply unit (1) according to any one of Claims 1 to 14, **characterized in that** a further coil (19), which is provided as a pancake coil on the first carrier plate (4), is disposed in the region of the alternating magnetic field, the further coil being connected to a monitoring unit (20).

## Revendications

1. Unité d'alimentation en énergie (1) destinée à transmettre une énergie auxiliaire à un circuit de commande (2) dans une installation à moyenne ou haute tension, l'unité d'alimentation en énergie (1) comprenant une bobine primaire (5) reliée au moins indirectement à une source d'énergie (7), une bobine secondaire (9) reliée au moins indirectement au circuit de commande (2), et une section d'isolation qui est formée entre la bobine primaire (5) et la bobine secondaire (9) et par laquelle s'effectue la transmission de l'énergie auxiliaire au moyen d'un champ magnétique alternatif, **caractérisée en ce qu'**une bobine primaire (5) sous la forme d'une bobine plate est formée sur une première plaque support (4) et une bobine secondaire (9) sous la forme d'une bobine plate est formée sur une deuxième plaque support (8), les deux plaques supports (4, 8) étant agencées à une distance définie l'une de l'autre et la section d'isolation se présentant sous la forme d'un espace d'air (11) entre la bobine primaire (5) et la bobine secondaire (9).

2. Unité d'alimentation en énergie (1) selon la revendication 1, **caractérisée en ce que** l'énergie auxiliaire se présente sous la forme d'une tension continue (U_v), étant précisé qu'il est prévu entre la source d'énergie (7) et la bobine primaire (5) un circuit oscillateur (6) qui produit à partir d'une tension d'entrée continue (U_d) délivrée par la source d'énergie (7) une tension alternative destinée à alimenter la bobine primaire (5) et **en ce qu'**un circuit (10) de redressement de la tension de sortie (U_v) est agencé entre la bobine secondaire (9) et le circuit de commande (2).

3. Unité d'alimentation en énergie (1) selon la revendication 2, **caractérisée en ce que** le circuit (10) de redressement de la tension de sortie (U_v) stabilise et/ou lisse.

4. Unité d'alimentation en énergie (1) selon la revendication 2 ou la revendication 3, **caractérisée en ce que** la tension alternative a une allure au moins sensiblement sinusoïdale.

5. Unité d'alimentation en énergie (1) selon l'une quelconque des revendications 2 à 4, **caractérisée en ce que** le circuit oscillateur (6) comporte un condensateur pour compenser la puissance réactive.

6. Unité d'alimentation en énergie (1) selon l'une quelconque des revendications 1 à 5, **caractérisée en ce que** la bobine primaire (5) et la bobine secondaire (9) sont formées en spirale sur les plaques supports (4, 8).

7. Unité d'alimentation en énergie (1) selon la revendication 6, **caractérisée en ce que** les plaques supports (4, 8) sont agencées l'une par rapport à l'autre de façon que le centre (16) de la bobine primaire (5) soit situé en regard du centre (17) de la bobine secondaire (9).

8. Unité d'alimentation en énergie (1) selon l'une quelconque des revendications 1 à 7, **caractérisée en ce qu'**au moins une plaque isolante (12) est agencée dans l'espace d'air (11) séparant les plaques supports (4, 8).

9. Unité d'alimentation en énergie (1) selon la revendication 8, **caractérisée en ce qu'**il est agencé, dans l'espace d'air (11) entre les plaques supports (4, 8), une plaque isolante (12) de plus grande surface que les plaques supports (4, 8), les bords de la plaque isolante (12) dépassant latéralement des bords des plaques supports (4, 8).

10. Unité d'alimentation en énergie (1) selon l'une quelconque des revendications 1 à 9, **caractérisée en ce que** les plaques supports (4, 8) sont agencées à équidistance l'une de l'autre au moins au niveau de la bobine primaire (5) ou de la bobine secondaire (9).

11. Unité d'alimentation en énergie (1) selon la revendication 10, **caractérisée en ce que** des entretoises (14, 15) sont agencées entre les plaques supports (4, 8) ou entre lesdites plaques supports (4, 8) et la ou les plaques isolantes (12).

12. Unité d'alimentation en énergie (1) selon la revendication 11, **caractérisée en ce que** les plaques supports (4, 8) ou la ou les plaques isolantes (12) sont fixées aux entretoises (14, 15).

13. Unité d'alimentation en énergie (1) selon la revendication 11 ou la revendication 12, **caractérisée en ce qu'**il est prévu chaque fois trois entretoises (14, 15) entre les plaques supports (4, 8) ou entre les plaques supports (4, 8) et la ou les plaques isolantes (12).

14. Unité d'alimentation en énergie (1) selon la revendication 13, **caractérisée en ce que** les entretoises (14) agencées entre la première plaque support (4) et la ou les plaques isolantes (12) et l'entretoise (15) agencée entre la deuxième plaque support (8) et la ou les plaques isolantes (12) sont fixées à la ou auxdites plaques isolantes (12) en étant décalées l'une par rapport à l'autre.

15. Unité d'alimentation en énergie (1) selon l'une quelconque des revendications 1 à 14, **caractérisée en ce qu'**il est agencé, au niveau du champ magnétique alternatif, une bobine supplémentaire (19) formée en tant que bobine plate sur la première plaque support (4) et raccordée à une unité de contrôle (20).
